Europäisches Patentamt

European Patent Office

Office européen des brevets

(19)

(11) Numéro de publication: **0 099 782**

**A1**

(12) # DEMANDE DE BREVET EUROPEEN

(21) Numéro de dépôt: **83401317.9**

(22) Date de dépôt: **24.06.83**

(51) Int. Cl.³: **H 01 L 33/00**
**H 01 S 3/19**

(30) Priorité: **06.07.82 FR 8211840**

(43) Date de publication de la demande:
**01.02.84 Bulletin 84/5**

(84) Etats contractants désignés:
**DE GB NL SE**

(71) Demandeur: **THOMSON-CSF**
**173, Boulevard Haussmann**
**F-75379 Paris Cedex 08(FR)**

(72) Inventeur: **Carballes, Jean-Claude**
**THOMSON-CSF SCPI 173, bld Haussmann**
**F-75379 Paris Cedex 08(FR)**

(72) Inventeur: **Mesquida, Guy**
**THOMSON-CSF SCPI 173, bld Haussmann**
**F-75379 Paris Cedex 08(FR)**

(72) Inventeur: **Gautier, Pierre**
**THOMSON-CSF SCPI 173, bld Haussmann**
**F-75379 Paris Cedex 08(FR)**

(74) Mandataire: **Taboureau, James et al,**
**THOMSON-CSF SCPI 173, Bld Haussmann**
**F-75379 Paris Cedex 08(FR)**

(54) **Contact ohmique localisateur dans la couche de contact d'un dispositif semi-conducteur émetteur de lumière.**

(57) L'invention concerne les dispositifs semiconducteurs émetteurs de lumière, tels que les lasers et les diodes électroluminescentes.

Un tel dispositif comprend, sur sa face du côté opposé à celui du substrat, une métallisation (5) de prise de contact et une couche dans laquelle est diffusé un contact localisateur (7). La couche de contact est, selon l'invention, dédoublée en deux couches du même matériau. La première couche (11), de forte épaisseur ($e_1$), est de même type de conductivité que la couche de confinement (2) sous-jacente. La deuxième couche (12), de faible épaisseur ($e_2$), est de type de conductivité opposé. La diffusion d'un contact localisateur du premier type de conductivité reconstitue une chaîne ohmique; la deuxième couche (12) constitue une diode autour du contact localisateur.

Application aux lasers et photodiodes émittrices.

FIG.3

# CONTACT OHMIQUE LOCALISATEUR DANS LA COUCHE DE CONTACT D'UN DISPOSITIF SEMICONDUCTEUR EMETTEUR DE LUMIERE

La présente invention concerne une structure de prises de contact électrique dans un dispositif semiconducteur émetteur de lumière, cette structure permettant d'améliorer la localisation du contact et, par voie de conséquence, la localisation de l'injection de courant et de l'émission de lumière par le dispositif semiconducteur.

Elle s'applique plus particulièrement aux diodes photoémettrices et aux diodes lasers, et convient lorsque la lumière est émise soit dans le plan d'une couche de matériaux dite couche active, par une face latérale clivée de la pastille de laser, soit perpendiculairement à cette couche active, à travers les autres couches constitutives transparentes de la pastille, et donc par la face supérieure libre de la diode.

Afin de rendre l'exposé de l'invention plus clair, celui-ci s'appuiera sur le cas d'un laser.

On sait qu'un laser semiconducteur comporte au moins une couche dite active, émettrice de lumière, définie entre une ou deux couches de confinement. Le courant injecté depuis une couche de contact, adjacente à une couche de confinement, vers le substrat, adjacent à une autre couche de confinement, créé l'émission de lumière par la couche active. L'un des problèmes des dispositifs semiconducteurs émetteurs de lumière est la localisation de l'injection de courant pour localiser l'émission de lumière.

Une solution connue consiste à définir le contact ohmique localisateur au moyen d'une jonction polarisée en inverse, qui, s'étendant à l'entour du contact ohmique, le circonscrit et s'oppose au passage du courant. Mais la réalisation d'une jonction entraîne, en cours de fabrication, le dépôt d'une couche supplémentaire, de type de conductivité opposée à celui de la couche d'injection sur laquelle s'appuie le contact ohmique. Il faut donc reconstituer le contact ohmique à travers la couche supplémentaire, par une diffusion appropriée et de profondeur suffisante pour supprimer la jonction, qui à l'intérieur du contact ohmique ferait diode.

Par ailleurs, les couches d'injection et supplémentaires constituent toujours une hétérostructure, c'est-à-dire qu'elles sont composées de deux matériaux différents. La raison en est qu'il est difficile de prendre un bon contact électrique sur un matériau de couche de confinement qui a de bonnes qualités optiques. La différence de nature des matériaux de ces deux couches entraîne une différence des caractéristiques de diffusion à travers ces deux couches, ce qui aboutit à une mauvaise définition de la localisation du courant d'injection.

L'invention assure une meilleure définition de la localisation du courant, en réalisant la diffusion à travers deux couches du même matériau, mais de types de conductivités opposées. Les matériaux étant les mêmes, les caractéristiques de diffusion sont les mêmes, et la diffusion est régulière. La couche d'injection supporte, selon l'invention, deux couches supplémentaires, celle qui est adjacente à la couche d'injection étant du même type de conductivité que celle-ci.

De façon plus précise l'invention concerne un contact ohmique localisateur dans la couche de contact d'un dispositif semiconducteur émetteur de lumière, comprenant, déposé sur un substrat porteur d'une première métallisation de prise de contact, une couche active, et une couche de confinement d'un premier type de conductivité, ce contact ohmique localisateur étant caractérisé en ce qu'il est réalisé par diffusion d'impuretés du premier type de conductivité dans deux couches d'un même matériau constituant la couche de contact, la première de celles-ci, adjacente à la couche de confinement, étant du premier type de conductivité, et la seconde, qui supporte la seconde métallisation de prise de contact, étant de conductivité de type opposé.

L'invention et ses avantages seront mieux compris par la description suivante de trois exemples d'applications, lesquels s'appuient sur les figures annexées qui représentent :

- figure 1: vue en coupe d'un dispositif semiconducteur émetteur de lumière selon l'art connu

- figure 2 :vue en coupe du contact ohmique localisateur du dispositif de la figure 1

- figure 3 : vue en coupe d'un dispositif semiconducteur émetteur de lumière selon l'invention, dans un premier exemple d'application avec émission de lumière par une face clivée du cristal

- figure 4 : vue en coupe du contact ohmique localisateur selon l'invention dans un deuxième exemple d'application

- figures 5 à 8 : principales étapes de réalisation du contact ohmique de la figure 4

- figure 9 : vue en coupe d'un dispositif semiconducteur émetteur de lumière selon l'invention, dans un troisième exemple d'application, avec émission de la lumière par la face supérieure de la pastille de cristal.

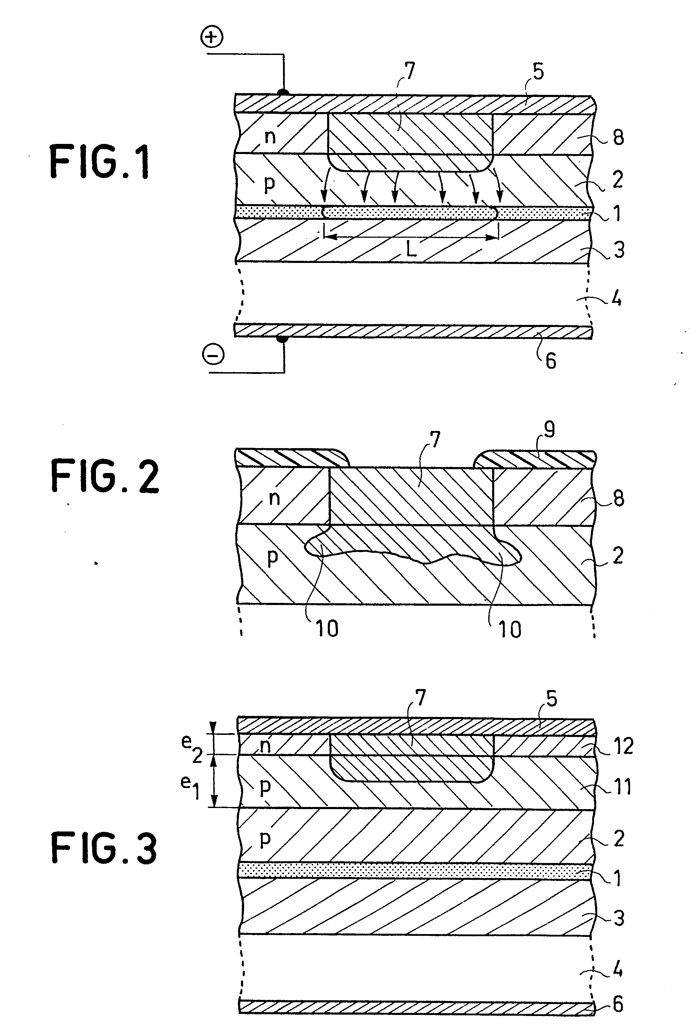

La figure 1 représente une vue en coupe d'un dispositif semiconducteur émetteur de lumière selon l'art connu. Cette figure ainsi que la structure émettrice elle-même sont simplifiées car l'invention porte essentiellement sur la localisation de l'injection de courant et non pas sur la structure du dispositif émetteur qui peut être, comme cela a été dit soit une photodiode soit un laser. Dans le cas présent, la figure 1 représente un laser à géométrie dit de ruban, c'est-à-dire qu'il émet la lumière à travers une face latérale clivée de la pastille du semiconducteur.

Une structure émettrice de lumière comporte essentiellement une couche active 1 délimitée par une double hétérostructure, par deux couches de confinement 2 et 3. La couche de confinement inférieure 3 est supportée par un substrat 4. C'est le courant injecté entre une première électrode 5, déposée à la surface libre du dispositif semiconducteur, et une deuxième électrode 6 déposée sous le substrat, qui définit l'injection de courant et, par voie de conséquence, la largeur L du ruban émetteur de lumière, dans le présent cas d'un laser à géométrie ruban.

Le courant injecté dans la couche active 1 est délimité par un contact ohmique localisateur 7, qui est ajdacent à la couche de confinement supérieure 2, laquelle est également appelée couche d'injection.

En fait, les dimensions du ruban d'injection, c'est-à-dire la largeur L étant de très faibles dimensions, par exemple 3 microns, il est extrêmement délicat de déposer à la surface de la couche d'injection 2 un ruban métallique de 3 microns de largeur seulement et il est préférable de déposer à la surface libre du cristal une métallisation 5 de plus grande largeur à partir de laquelle on définit un contact ohmique localisateur.

Une technique couramment employée, et qui a été précédemment citée, consiste à déposer par dessus la couche d'injection ou de confi-

4

nement 2 une couche supplémentaire 8 appellée couche de contact. La couche de contact 8 et la couche de confinement 2 sont de type de conductivité opposée, l'une étant de type n et l'autre de type p. Il se forme donc entre ces deux couches une jonction, organisée de telle façon qu'elle soit polarisée en inverse pour les conditions de fonctionnement du dispositif émetteur de lumière : par exemple, si une tension d'alimentation positive est appliquée sur la couche de contact 8 et une tension d'alimentation négative est appliquée sur le substrat 4 du dispositif, la couche de confinement 2 est de type p et la couche de contact 8 est de type n. Il est évident que si les polarités étaient inversées, le type de conductivité de ces deux couches serait également inversé.

Le contact ohmique localisateur 7 doit alors être reconstitué à travers la couche de contact 8 de telle façon qu'entre la métallisation 5 et la couche de confinement 2 il n'y est plus de jonction de type pn ou np : la reconstitution du contact ohmique localisateur se fait par une diffusion à travers la couche de contact d'impuretés dont la nature est choisie pour obtenir le type de conductivité désiré. Par exemple, si la couche de confinement 2 est en GaAlAs de type p et la couche de contact 8 est en GaAs de type n, le zinc conviendra pour reconstituer une région 7 de type p à travers la couche de contact 8 de type n.

De façon à s'assurer qu'entre le contact ohmique localisateur 7 et la couche de confinement 2 ne demeure pas une faible pellicule de couche de contact 8, ce qui présenterait donc un effet de diodes, ou en raison des irrégularités possibles dans l'épaisseur des couches qui ont été déposées par épitaxie, il est toujours préférable de pousser la diffusion de façon suffisamment profonde pour que le contact localisateur 7 pénètre légèrement dans la couche de confinement 2.

Le dessin du contact ohmique localisateur 7 sur la figure 1 correspond en fait à un cas idéal, selon lequel la diffusion progresse de façon régulière et permet de délimiter de façon précise la région d'injection de courant.

Mais dans la réalité, les matériaux des couches de confinement et de contact, 2 et 8, étant de natures différentes, le contact ohmique est moins bien localisé que ce qui est représenté en figure 1.

La figure 2, qui ne reprend que la partie intéressant le contact localisateur de la figure 1, et est simplifiée du côté des couches profondes et du substrat, représente le profil de diffusion réel à travers les couches de contact 8 et de confinement 2.

Pour réaliser un contact ohmique localisateur, lorsque la couche de confinement 2 et la couche de contact 8 ont été épitaxiées sur le dispositif semiconducteur, un masque d'oxyde 9, par exemple, est déposé sur la surface libre de la couche de contact 8 et une ouverture correspondante au contact à réaliser est faite dans ce masque d'oxyde. La diffusion de dopants de façon à donner au contact localisateur 7 le même type de conductivité que la couche de confinement 2 progresse dans la couche de contact, en fonction de certaines caractéristiques liées à la nature de la couche de contact qui est, par exemple GaAs. Lorsque le front de diffusion atteint la couche de confinement 2, qui est par exemple GaAlAs, le front de diffusion pénètre alors dans cette couche de nature différente avec des caractéristiques différentes et il s'ensuit une irrégularité du front de diffusion, en particulier une diffusion latérale, mise en évidence en 10, cette diffusion latérale entraînant l'inconvénient que le contact ohmique localisateur est moins bien défini que le masque d'ouverture à travers la couche d'oxyde 9.

C'est donc parce que les deux matériaux des couches de confinement 2 et de contact 8 sont différents et que les caractéristiques de diffusion à travers ces matériaux sont différentes que le contact localisateur est moins bien défini que prévu. L'invention, dans son fondement, permet de réaliser la reconstitution du contact ohmique localisateur à travers deux couches de matériaux de type de conductivité différents, mais ces deux couches étant faites du même matériau, GaAs par exemple.

C'est ce que représente la figure 3 qui donne une vue en coupe d'un dispositif semiconducteur émetteur de lumière, doté d'une structure de prise de contact localisé selon l'invention.

Pour faciliter le rapprochement entre l'art connu et l'invention, les mêmes indices de repères ont été conservés lorsqu'ils désignent les mêmes objets. On retrouve sur la figure 3 la configuration de base d'un dispositif semiconducteur émetteur de lumière, avec une couche active 1 comprise entre deux couches de confinement 2 et 3, et supportée par un substrat 4. La tension est appliquée entre deux électrodes 5 et 6 sur les deux faces principales du cristal du semiconducteur.

Mais la couche de contact, unique 8, dans l'art connu, est ici remplacée par une double couche de contact 11 et 12. Les deux couches de contact 11 et 12 sont réalisées dans le même matériau, par exemple GaAs, ou par exemple InP, mais elles sont dopées de façons différentes, la couche inférieure 11, qui est adjacente à la couche de confinement 2, étant du même type de conductivité que celle-ci. Puisque dans l'exemple de la figure 1, les types de conductivité avaient été, arbitrairement et pour l'exemple, choisis p pour la couche de confinement et n pour la couche de contact, et de façon à conserver la comparaison, la couche de confinement 2 de la figure 3 est de type p, la première couche de contact 11 est également de type p et par conséquent la deuxième couche de contact 12 est de type n.

En outre, la première couche de contact 11 est déposée, par épitaxie par exemple, sous une épaisseur $e_1$, qui est de beaucoup plus importante que l'épaisseur $e_2$ de la seconde couche de contact 12. Ceci permet, s'il y a des inégalités entre l'épaisseur $e_2$ de la couche 12 en différents points de la plaquette, au cours de la fabrication des émetteurs de lumière, de s'assurer que la diffusion par laquelle est réalisé le contact localisateur percera dans tous les cas la seconde couche de contact 12 et atteindra la première couche de contact 11. Si la seconde couche de contact 12 était trop épaisse, il y aurait des risques, en fabrication, que certaines diffusions 7 ne percent pas cette couche 12 et n'atteignent pas la couche 11.

Les deux couches 11 et 12 qui constituent la couche de contact étant réalisées dans le même matériau, la vitesse de diffusion d'un agent dopant pour réaliser le contact localisateur 7 est identique dans les deux couches et par conséquent il n'y a plus de diffusion latérale 10 telle que représentée en figure 2, et le front de propagation de la diffusion est beaucoup plus régulier.

En outre, il y a continuité entre la métallisation 5, le contact ohmique 7, qui dans le présent exemple est de type p, la première couche de contact 11 qui est aussi de type p et la couche de confinement 2 qui est toujours de type p : il n'y a donc pas entre la métallisation 5 et la couche active 1 une jonction qui fasse effet de diode.

De plus, la première couche de contact 11 est dopée à faible niveau, ce qui lui confère une certaine résistivité, sans importance dans le sens de son épaisseur, mais qui a l'avantage de s'opposer à l'élargissement des lignes de courant dans le sens latéral, et donc participe à la localisation du contact.

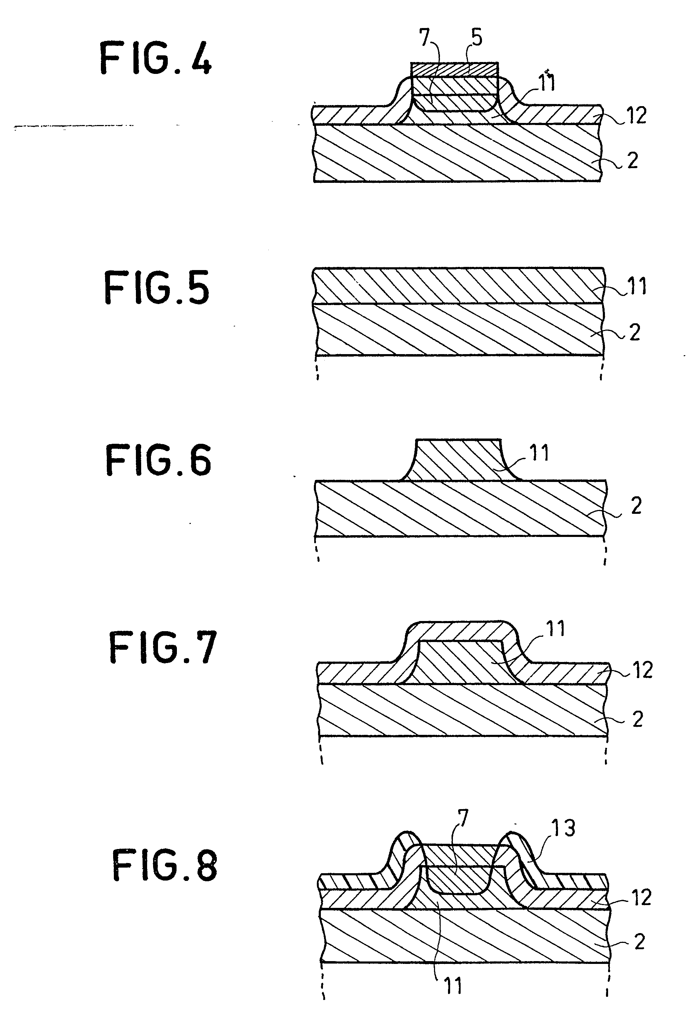

La figure 4 représente une vue en coupe d'un contact ohmique localisateur selon l'invention, dans un second exemple d'application.

Sur cette figure, ainsi que sur les suivantes, seules ont été conservées les parties supérieures du schéma du dispositif semiconducteur photoémetteur. La couche à partir de laquelle est représentée la structure est la couche 2 qui est sur les précédentes la couche d'injection ou de confinement.

On voit sur la figure 4 que le contact ohmique localisateur selon l'invention, déposé sur la couche de confinement 2, est bien comme précédemment constitué d'une couche 11 dans un matériau d'un premier type de conductivité, p par exemple, et d'une couche 12 du même matériau dans un autre type de conductivité, n par exemple. Le contact ohmique localisateur 7 a été diffusé ou implanté à travers la couche 12 jusque dans la couche 11, et une métallisation d'électrode 5 est déposée à la surface libre du dispositif.

L'aspect nouveau dans cette configuration de contact localisateur est que la couche inférieure, c'est-à-dire la couche 11 de type p dans ce cas d'exemple, est elle-même localisée, ce qui permet de la doper davantage, d'où une résistance série moindre et un meilleur fonctionnement du dispositif photoémetteur. La couche inférieure 11 a donc une forme localisée dite "mésa".

Le procédé d'obtention d'un tel contact localisateur est illustré par les figures 5 à 8.

Sur la figure 5, n'est donc représenté comme cela vient d'être dit que la couche supérieure 2, couche de confinement de la structure photoémettrice. Sur cette couche 2 est déposée par épitaxie une première couche 11 d'un matériau d'un premier type de conductivité, p par exemple, puis cette couche 11 est attaquée par voie chimique ou par usinage ionique de façon à former un mésa, montré par la figure 6. Une seconde couche 12 du même matériau mais dans un autre type de conductivité n par exemple est déposée à la surface du mésa 11 et de la couche de confinement 2, en dehors du mésa (figure 7), puis un masquage par une résine ou par une couche de diélectrique 13 (en oxyde) est réalisé à la surface de la seconde couche 12, avec ouverture du masque sur la partie supérieure du mésa 11 : une diffusion est alors faite à travers la couche 12 jusque dans le mésa 11, de façon à donner un contact localisateur 7 du même type de conductivité que le mésa 11 et que la couche de confinement 2.

En ce qui concerne la métallisation de contact 5, deux cas sont possibles. La solution la plus simple consiste à déposer une métallisation sur le plateau du mésa, c'est-à-dire dans la face libre de la couche 12 à l'aplomb du contact localisateur. Mais si les conductivités sont à titre d'exemple p pour la couche 11 et n pour la couche 12, il devient plus intéressant de rôder ou de supprimer la couche 12 sur la partie supérieure du mésa, -et bien entendu de la conserver à l'extérieur de cette zone de contact localisé, -et de déposer la métallisation de contact 5 directement sur la couche 11.

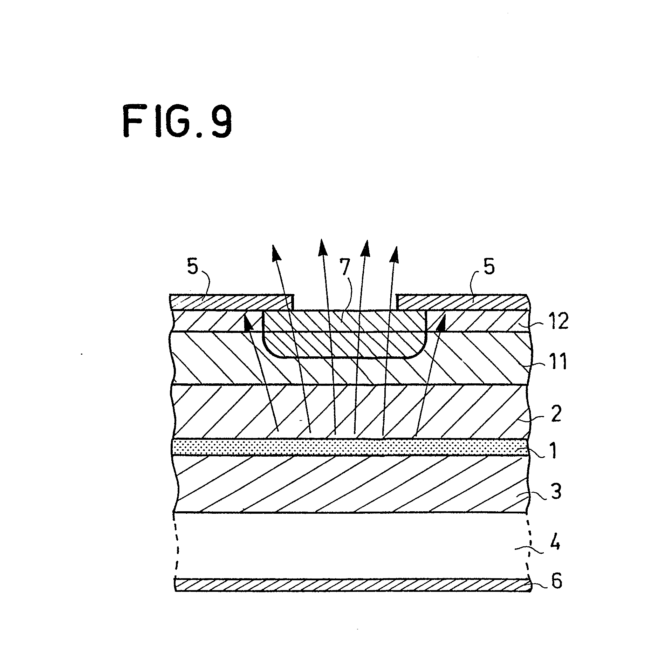

La figure 9 représente une vue en coupe d'un dispositif semiconducteur émetteur de lumière selon l'invention dans un troisième exemple d'application, avec émission de lumière par la face supérieure de la pastille.

La structure semiconductrice doit dans ce cas comporter des couches supérieures, c'est-à-dire celles qui se situent du côté de l'émission de lumière, transparentes afin que la lumière émise par la couche active 1 puissent être recueillies à l'extérieur par exemple par une fibre optique. De plus, il est nécessairè que la métallisation 5 de prise de contact sur la couche extérieure du dispositif présente une fenêtre, pour laisser passer la lumière, ce qui engendre que le contact ohmique localisateur 7 est dans ce cas de dimensions légèrement plus grandes que celles du faisceau de lumière émis, car il est nécessaire qu'il y ait sur ses bords un conctact électrique avec la métallisation 5.

L'invention a été décrite en s'appuyant sur des cas de figures dans lesquelles des matériaux tels que GaAs et GaAlAs ont été cités, et des types de conductivité p et n ont été donnés pour fixer les idées et simplifier les figures et les explications. Cependant, il est bien clair que ces précisions ne limitent en aucun cas l'invention qui s'applique essentiellement à un contact ohmique localisateur et à la façon de le réaliser. L'invention s'applique à tous dispositifs semiconducteurs réalisés à partir de matériaux tels que le germanium, le gallium, l'arsénic, l'aluminium, l'indium, le phosphore, l'antimoine et d'autres encore qui sont tous bien connus pour être utilisés seuls ou en alliage dans la réalisation de structures photoémettrices. et photoré-ceptrices. De plus, les types de conductivité qui ont été cités tels que par exemple.p pour la couche de confinement et p et n pour les deux couches de prise de contact peuvent être inversés sans pour autant sortir du domaine de l'invention, qui est précisé par les revendications suivantes.

10

REVENDICATIONS

1. Contact ohmique localisateur dans la couche de contact d'un dispositif semiconducteur émetteur de lumière, comprenant, déposé sur un substrat (4) porteur d'une première métallisation de prise de contact (6), une couche active (1) et une couche de confinement (2), d'un premier type de conductivité, ce contact ohmique localisateur (7) étant caractérisé en ce qu'il est réalisé par diffusion d'impuretés du premier type de conductivité dans deux couches (11, 12) d'un même matériau constituant la couche de contact, la première (11) de celles-ci, adjacente à la couche de confinement (2), étant du premier type de conductivité, et la seconde (12), qui supporte la seconde métallisation (5) de prise de contact, étant de conductivité de type opposé.

2. Contact ohmique selon la revendication 1, caractérisé en ce que l'épaisseur ($e_1$) de la première couche (11) constituant la couche de contact est très supérieure à l'épaisseur ($e_2$) de la deuxième couche (12)

3. Contact ohmique selon la revendication 1, caractérisé en ce que la niveau de dopage de la première couche (11) est faible, et ladite couche (11) peu dispersive des lignes de courant.

4. Contact ohmique selon la revendication 1, caractérisé en ce que le matériau des première (11) et seconde (12) couches est choisi pour avoir un paramètre de mailles cristallines compatible avec celui de la couche de confinement (2)

5. Contact ohmique selon la revendication 1, caractérisé en ce que la première couche (11) est gravée en forme de mésa avant le dépôt de la seconde couche (12)

6. Contact ohmique selon la revendication 5, caractérisé en ce que, la première couche (11) étant localisée à l'emplacement du contact, elle est fortement dopée et de faible résistance

7. Contact ohmique selon l'une quelconque des revendications 1 à 6 caractérisé en ce que, la couche de confinement étant réalisée en un premier matériau comprenant Ge, Ga, Al, As, In, P.Sb pris seuls ou en alliage ternaire, les première (11) et seconde (12) couches de contact sont

11

réalisées en un second matériau comprenant Ge, Ga, Al, As, In, P.Sb pris seuls ou en alliage binaire.

FIG.1

FIG.2

FIG.3

FIG.4

FIG.5

FIG.6

FIG.7

FIG.8

# FIG.9

0099782

Office européen
des brevets

**RAPPORT DE RECHERCHE EUROPEENNE**

Numéro de la demande

EP 83 40 1317

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | EP-A-0 042 585 (HITACHI)<br>* Page 2, ligne 20 - page 13, ligne 25; revendications; figures * | 1-4,7 | H 01 L 33/00<br>H 01 S 3/19 |
| | --- | | |
| A | US-A-4 048 627 (RCA)<br>* Colonne 1, ligne 67 - colonne 7, ligne 69; figures * | 1,5-7 | |
| | --- | | |
| A | US-A-4 206 468 (THOMPSON-CSF)<br>* Revendications; figures * | 1,5-7 | |
| | --- | | |
| A | GB-A-1 577 250 (HITACHI)<br>* Revendications; figures * | 1 | |
| | --- | | |
| A | US-A-4 194 933 (BELL TELEPHONE LABORATORIES)<br>* Revendications; figures * | 1 | **DOMAINES TECHNIQUES RECHERCHES (Int. Cl. ³)**<br><br>H 01 L<br>H 01 S |
| | ----- | | |

Le présent rapport de recherche a été établi pour toutes les revendications

| Lieu de la recherche<br>LA HAYE | Date d'achèvement de la recherche<br>14-10-1983 | Examinateur<br>GORUN M. |
|---|---|---|